(19) Europäisches Patentamt
European Patent Office
Office européen des brevets

(11) **EP 3 503 400 A1**

(12) **EUROPEAN PATENT APPLICATION**

(43) Date of publication:
**26.06.2019 Bulletin 2019/26**

(51) Int Cl.:
***H03K 17/693*** (2006.01)

(21) Application number: **18215578.8**

(22) Date of filing: **21.12.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.12.2017 GB 201721652**

(71) Applicant: **Nidec Control Techniques Limited Newtown, Powys SY16 3BE (GB)**

(72) Inventor: **TOWERS, Mark Newton, Powys SY16 3BE (GB)**

(74) Representative: **Smith, Jeremy Robert Kilburn & Strode LLP Lacon London 84 Theobalds Road London WC1X 8NL (GB)**

(54) **DRIVE LIFETIME EXTENSION**

(57) A method of controlling a switching frequency of a device is disclosed, the method comprising estimating a rate of temperature ripples experienced by the device; determining the total number of temperature ripples expected over a required lifetime of the device, based on the rate of temperature ripples; determining and setting a first temperature ripple limit based on the total number of temperature ripples expected over the required lifetime of the device; and controlling a switching frequency of the device based on the first temperature ripple limit.

Fig.1

**Description**

**Field**

The disclosure relates to a method for extending the lifetime of a device. Specifically, the disclosure relates a method of determining a limit for temperature ripples experienced by the device.

**Background**

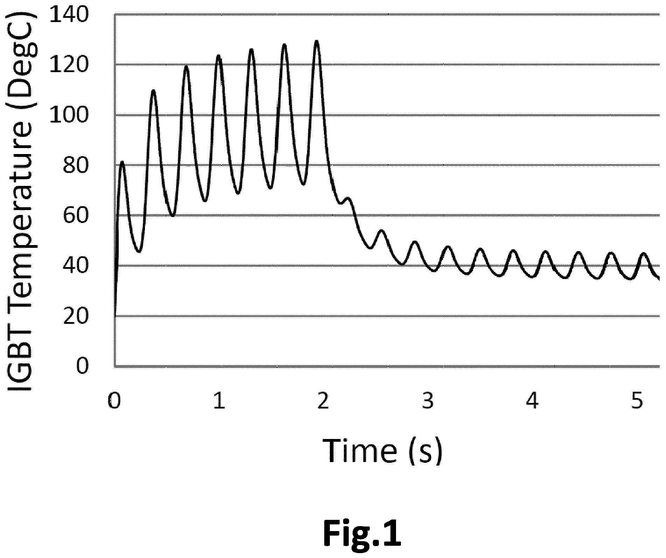

A variable speed drive is a device that controls machinery, for example the torque output of an electric motor. The power stage of a variable speed drive (VSD) typically consists of a number of power devices, for example IGBTs and diodes, packaged inside a power module. In many applications, for example elevator and high performance industrial applications, power cycling is the primary ageing mechanism that will limit the lifetime of these devices. This occurs when changes in the angle and/or magnitude of the drive's current output vector cause variation in the power dissipated in individual IGBT chips. It would be understood that the current output vector is the magnitude and direction of the output current. This results in temperature swings in the IGBT chips and their surroundings (known as temperature ripple). An example of temperature ripple is shown in Fig.1. The non-uniform expansion and contraction that results from these temperature swings causes mechanical wear that eventually leads to failure. Wear most commonly occurs in the solder layer connecting the chip to the substrate and in the bond wires used to make topside connections.

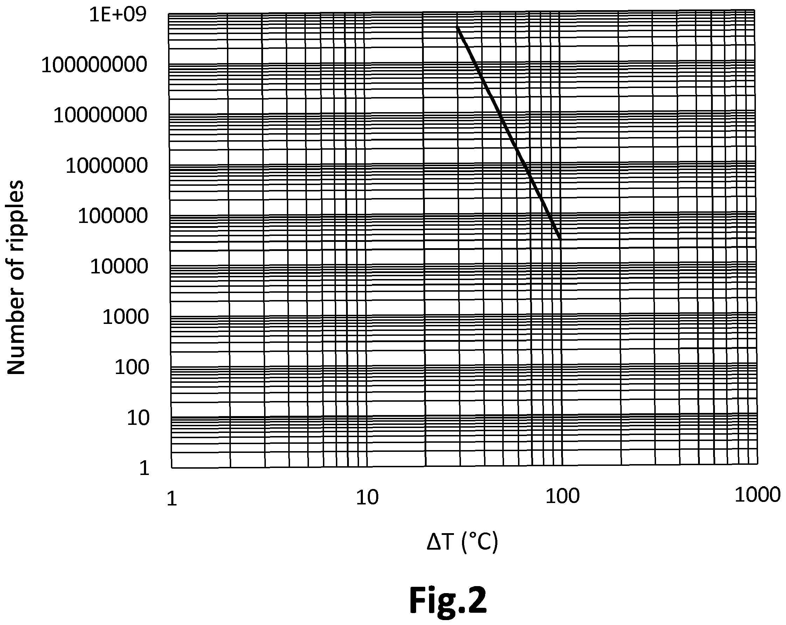

The lifetime of the power module is therefore determined by the magnitude and frequency of the temperature ripples to which it is subjected. The amount of wear associated with a particular temperature ripple is described in the manufacturer's lifetime curves. The lifetime is defined as the number of temperature ripples of a given magnitude that will lead to the theoretical end of life. An example characteristic for a power module is shown in Fig. 2, where the number of ripples is plotted on the vertical axis against the magnitude of the ripple on the horizontal axis. The amount of wear is inversely proportional to the lifetime and is considered linear, so that the total wear can be calculated by summing the wear caused by individual temperature ripples.

To mitigate the effects of temperature ripple, it is known from patent document US 2014/0346989 A1 to limit the peak device temperature ripple using switching frequency reduction. This is done by detecting temperature ripples that could cause excessive wear in the power module, for example by use of a pre-set temperature limit for the module. If a temperature ripple exceeds the limit, the switching frequency is reduced to reduce the magnitude of the temperature ripple and therefore-reduce the damage caused to the power module. This can extend the lifetime of the device.

The use of such a ripple limit is effective at limiting the maximum wear caused by temperature ripples. However, the performance in some applications may not be acceptable, leading either to unnecessary switching-frequency reduction or reduced product lifetime. It is also difficult for a user to configure the limit optimally.

**Summary**

In accordance with an aspect of the disclosure there is provided a method of controlling a switching frequency of a device, the method comprising estimating a rate of temperature ripples experienced by the device, determining the total number of temperature ripples expected over a required lifetime of the device, based on the rate of temperature ripples, determining and setting a first temperature ripple limit based on the total number of temperature ripples expected over the required lifetime of the device and controlling a switching frequency of the device based on the first temperature ripple limit.

Optionally, the required lifetime is a number of operation cycles that the device is expected to perform before failure. Optionally, the total number of temperature ripples expected over the required lifetime is further determined based on the number of operation cycles that the device is expected to perform and the duration of a single operation cycle. Optionally, the duration of a single operation cycle is the duration for which the device continuously has a non-zero output current. Optionally, the duration of an operation cycle is an average duration determined based on a duration of at least one previous operation cycle. Optionally, the at least one previous operation cycle is the preceding operation cycle.

Optionally, the required lifetime is a period for which the device is expected to operate before failure. Optionally, the total number of temperature ripples expected over the required lifetime is further determined based on the period for which the device should operate.

Optionally, determining the rate of temperature ripples comprises determining the instantaneous rate of temperature ripples experienced by the device. Optionally, determining the instantaneous rate of temperature ripples further comprises determining the instantaneous output frequency of the device. Optionally, the instantaneous rate of temperature ripples is estimated based on the instantaneous output frequency of the device. Optionally, the instantaneous rate of temperature ripples is considered equal to the instantaneous output frequency of the device. Optionally, the instantaneous rate of temperature ripples is considered equal to the sum of the instantaneous output frequency of the device and the frequency of operation cycles of the device.

Optionally, determining the first temperature ripple limit comprises matching the total number of temperature ripples to a magnitude of temperature ripples based on a characteristic of the device, the characteristic defining the total number of temperature ripples of a given magnitude that the device can withstand before failure. Optionally, the characteristic is determined by at least one of experimental results, computer simulation and data supplied by the device manufacturer. Optionally, the characteristic is at least one of a graphical curve, a lookup table and a set of polynomial coefficients.

Optionally, the method further comprises determining a second temperature ripple limit. Optionally, the second temperature ripple limit is determined in substantially the same manner as determining the first temperature ripple limit. Optionally, the first temperature ripple limit is used with a first portion of an operation cycle of the device and the second temperature ripple limit is used with a second portion of the operation cycle of the device. Optionally, the first portion of the operation cycle is a portion having a steady state frequency output and the second portion of the operation cycle is a portion having a transient frequency output.

Optionally, the device is a variable speed drive. Optionally, the variable speed drive is an elevator drive.

Optionally, the step of controlling the switching frequency comprises monitoring a temperature ripple experience by the device at a first switching frequency, determining if the monitored temperature ripple is above the first temperature ripple limit and if the monitored temperature ripple is above the first temperature ripple limit, setting the switching frequency of the device to a second switching frequency lower than the first switching frequency.

Optionally, the temperature ripple is a temperature ripple experienced by a component of the device. Optionally, the component of the device is the component of the device with the highest absolute temperature in operation. Optionally, the component of the device is a p-n junction of an inverter of the device. Optionally, the second switching frequency is higher than a predetermined minimum switching frequency.

**Brief Description of the Drawings**

Exemplary embodiments of the disclosure shall now be described with reference to the drawings in which:

Fig. 1 shows an example plot of temperature ripple in a variable speed drive;
Fig. 2 shows an example lifetime characteristic of a variable speed drive;
Fig. 3 shows an example configuration for a variable speed drive;
Fig. 4 shows a method of setting a limit for temperature ripple;
Fig. 5 shows a method of controlling a drive using the limit; and
Fig. 6 shows a plot of an example operation cycle for an elevator drive.

Throughout the description and the drawings, like reference numerals refer to like parts.

**Specific Description**

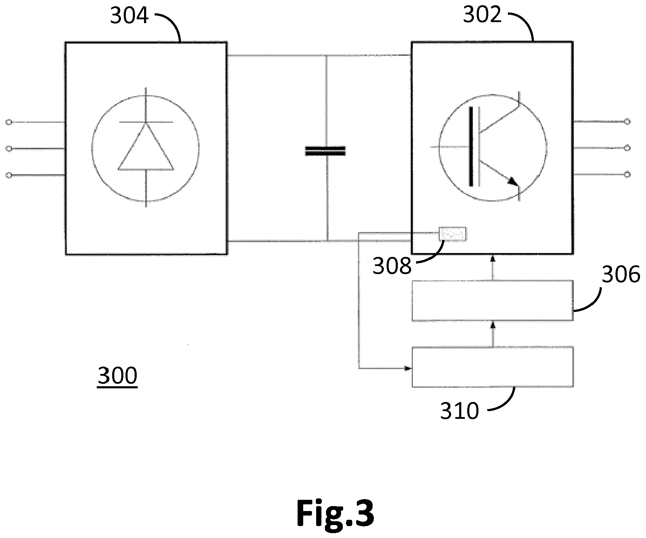

Referring to Fig. 3, a simple configuration for a VSD 300, such as an elevator drive, is shown. The VSD 300 includes an inverter 302, a rectifier 304, a gate driver 306, a thermistor 308 and a pulse width modulation (PWM) controller 310. The configuration 300 is well known to the skilled person. A direct current (DC) source (not shown) provides DC to the VSD 300. In some embodiments, one or more phases of the rectifier 304 is powered from an external (AC) mains supply, for example a 3-phase supply, which provides a DC source to the inverter 302. In addition to or instead of the rectifier power supply, the DC bus can be supplied by an external DC supply for example the DC bus of another VSD. The inverter 302 produces alternating current (AC) from the DC input, which is typically used to drive a load, for example a motor via output terminals of the VSD. The rectifier 304 is connected across the inverter 302 in order to provide a path for the peak inductive load current when the inverter 302 is turned off. Temperature feedback is obtained by a module such as the thermistor 308 which feeds the value to the PWM controller 310 to control the switching frequency of the inverter 302 via the gate driver 306. The inverter 302 can include multiple diodes, IGBTs and drivers.

According to US 2014/0346989A1, the magnitude of the temperature ripples experienced by components in a power module of the VSD 300 may be maintained below a user defined limit using switching frequency reduction. In order to optimise the lifetime of a drive such as the drive 300, defined for example by a number of operation cycles that the drive 300 should be able to perform before power module failure, the limits used by the controller 310 to control the temperature ripples should be set accordingly. It is known to set fixed values of these limits; however, this approach does not take into account changes to the operating conditions and/or desired operation of a particular power module or drive.

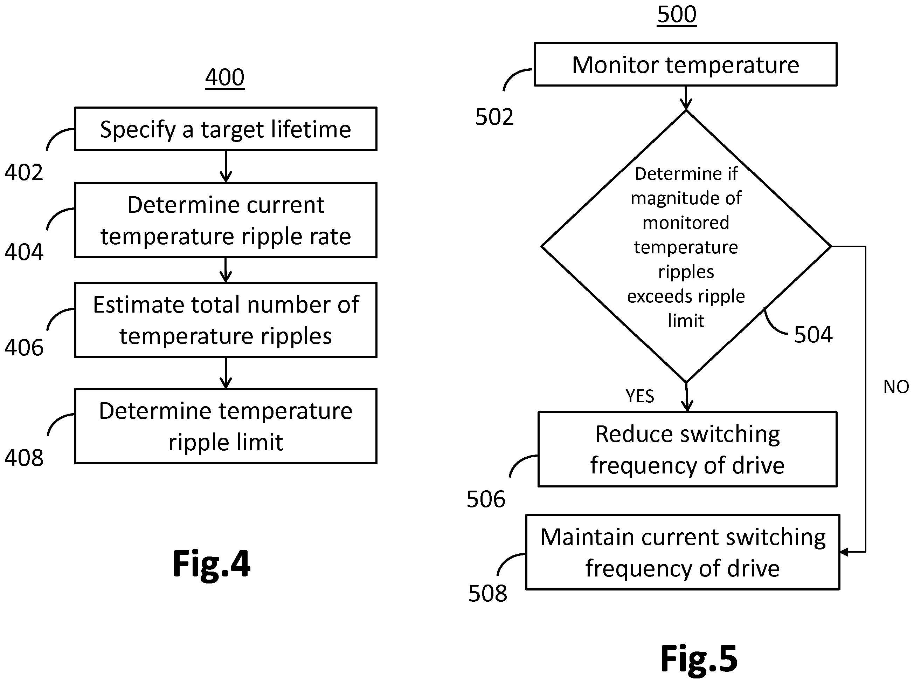

Fig. 4 shows a method 400 of setting a limit for temperature ripples, which can be used by the controller 310 in a VSD such as the drive 300, for example in an elevator or other industrial power cycling applications, to monitor temperature ripples and adjust the switching frequency accordingly.

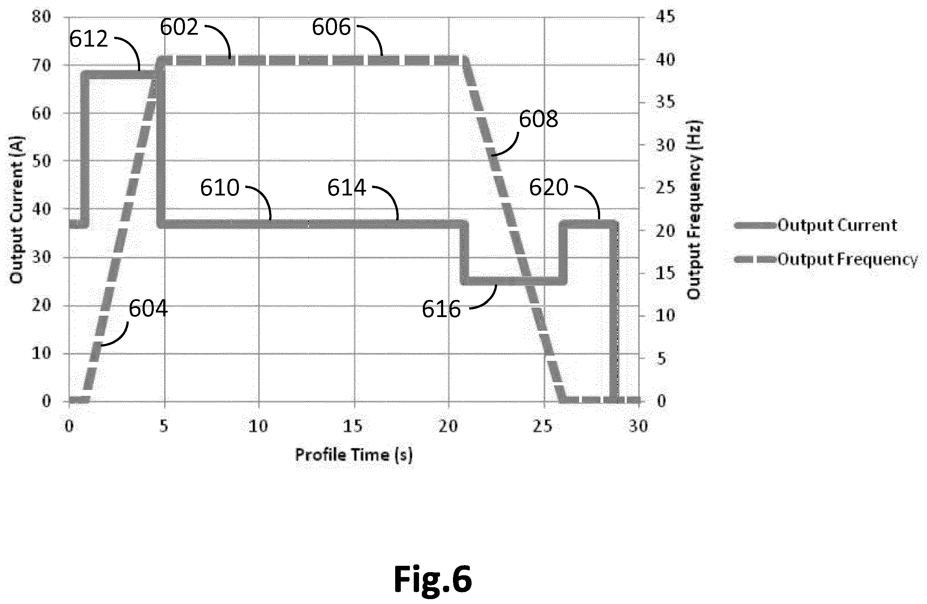

At step 402, a target lifetime is specified for the drive 300. This can be specified as a number of operation cycles that the drive 300 should be able to perform before failure or as a timespan of desired operation, for example in hours. A simple interpretation of an operation cycle is a period of time over which temperature ripples could occur (i.e., the output current of the drive is above zero). In elevator applications, for example, each operation cycle corresponds to a single elevator journey, and so the lifetime is specified as the number of elevator journeys required before failure. The profile of a typical operation cycle for an elevator drive is shown in Fig. 6, which will be discussed below.

At step 404, the current temperature ripple rate is estimated. In a VSD such as the drive 300, as each change in the drive's output vector can cause a temperature ripple, the ripple rate estimation can be achieved by monitoring the drive's output vector. For example, when a VSD is operating at a constant output frequency under constant load, the temperature ripple rate (the number of temperature ripples per unit time) is typically directly proportional to the output frequency. Alternatively, when the VSD operates at zero speed under variable load, each change in the output current can cause a temperature ripple in some of the power devices (the number and location of devices depend on inverter design and modulating scheme). Typically, applications fall between one of these two extremes, so that some temperature ripples may be attributed to output frequency (i.e., changes in output position) and some may be attributed to output current. Short changes in power dissipation, such as rapid changes in output current or operation at high output frequencies, may not result in significant temperature swings due to the time constants of the power devices.

For typical applications, most temperature ripples can be attributed to output frequency, so that considering the ripple rate for a single power module as equal to the output frequency will produce a good estimate of the ripple rate. This has the advantage that the output frequency is typically known with good accuracy in most VSD implementations.

This estimate of ripple rate can be improved by adding the number of ripples caused by changes in output current. This can be difficult to measure in real time, however for most applications it can be assumed that at least one ripple per operating cycle will occur due to output current, as typically a system will go from a low or zero current state (start of cycle) into a high current state and return to a low or zero current by the end of the cycle. It is possible to improve the estimate of ripple rate due to output current by applying additional system knowledge at design time, and optionally measurement and computational resources at run-time, but for many applications assuming one additional ripple per operational cycle is sufficient.

The estimate of ripple rate is calculated according to equation 1, below:

$$F_{ripple} = F_{out} + F_{OutputCurrentRippleEstimate} \quad (1)$$

where $F_{out}$ is the output frequency and $F_{OutputCurrentRippleEstimate}$ is the estimated frequency of ripples caused by the changes in output current. As explained above, assuming one additional ripple per operational cycle is sufficient, $F_{OutputCurrentRippleEstimate}$ can be estimated as the frequency of operating cycles.

The reasoning used to describe the estimation process above assumes constant frequency operation. However, as wear is linear, this logic can be extended to variable speed operation. A direct, memoryless implementation of this system would use the instant output frequency to determine $F_{ripple}$. This leads to a ripple limit that would decrease with increasing output frequency. As the temperature ripple also decreases with increased output frequency (due to the thermal time constant of the power components), this is a desirable feature as it tends to maximise the time at higher switching frequencies without compromising lifetime. It is generally desirable to operate at higher switching frequencies to minimise audible noise. In some cases however, the switching frequency must be reduced below a default level, for example from 16kHz to 12kHz, to lower switching losses and hence lower the temperature ripple in order to meet the ripple limit. Using the approach discussed above, the method reduces the magnitude and duration of switching frequency reduction applied over the device's lifetime, thus maximising operation at higher switching frequencies.

At step 406, an estimate is made of the total number of temperature ripples that will occur across the target lifetime of the drive 300 due to changes in the output vector of the power module. This is calculated according to equation 2 or 3, below:

$$N_{ripples} = F_{ripple} \times t_{cycle} \times N_{lifetime} \quad (2)$$

$$N_{ripples} = F_{ripple} \times t_{lifetimerequirement} \quad (3)$$

where $N_{ripples}$ is the estimated total number of ripples, $F_{ripple}$ is the current temperature ripple rate determined at step 404, $t_{cycle}$ is the typical duration for an operation cycle of the drive 300, $N_{lifetime}$ is the target number of operation cycles and is $t_{lifetimerequirement}$ is the timespan of desired operation. Equation 2 is used when the lifetime target is specified as a number of operation cycles at step 402, and equation 3 is used when the lifetime target is specified as a time at step 402.

The typical duration for an operation cycle may be updated online, for example after each operation cycle that the drive 300 performs, by feeding back the latest operation cycle duration to the controller 310. This ensures an accurate representation of typical drive operation. Alternatively, a constant value could be used for the operation cycle duration. Optionally, the constant value is higher than the required value to compensate for uncertainty in the input data. This ensures that the number of ripples is overestimated and safe operation is ensured.

At step 408, the estimated total number of temperature ripples across the target lifetime is used to determine a temperature ripple limit. The temperature ripple limit is a value of temperature used as a threshold for the magnitude of the temperature swing for an individual ripple, such as one of the ripples shown in Fig.1. As discussed above, power module manufacturers describe the lifetime of a power module in terms of the number of temperature swings that will result in the power module reaching end of life for a given operating temperature. An example curve is shown in Fig. 2. The ripple limit is determined by cross-referencing the estimated total number of temperature ripples (determined at step 406) for the required lifetime duration (specified at step 402) with such a lifetime characteristic to give a required ripple magnitude to which the ripples should be limited. The characteristic could be created in a number of ways, for example by experimental results, computer simulation or data supplied by the component manufacturer. The characteristic could also be an approximation of the understood lifetime profile to minimise the use of computational resources (processor time, memory etc.). Such characteristics could for example be implemented as a lookup table, polynomial coefficients or other means as would be understood by someone skilled in the art.

This system provides the flexibility to raise the ripple limit by reducing output frequency, so that a higher ripple can be tolerated if this is permissible in the application. If significant variation in the ripple limit during a single operational cycle is not desired, a representative value of output frequency could be used, for example an average of the output frequency, to calculate a single ripple limit value.

Fig. 5 shows a method 500 of using the calculated ripple limit to control operation of a drive such as the drive 300. At step 502, the temperature of the power module, and therefore the temperature ripple experienced by the power module, is monitored. Temperature monitoring can be applied either to the power module as a whole or to individual power devices inside the module. Where temperature monitoring is applied to individual components, for example by detecting the temperature at each component or by inputting the operating conditions of each component to a power loss model, the approach can be further optimised. For example, temperature values can be derived from the component operating at the highest temperature, allowing the component in the power module experiencing the highest temperature ripple (for example an IGBT or a diode) to control the operation of the drive 300. This helps to reduce the temperature ripple regardless of the absolute value of temperature, thereby increasing the lifetime of the power module whilst attaining optimised operation of the drive.

At step 504, a determination is made as to whether or not the magnitude of the temperature ripple of any monitored temperature ripples exceeds the ripple limit. If the magnitude exceeds the ripple limit, the switching frequency of the drive 300 is reduced, at step 506, in order to in turn reduce the magnitude of the temperature ripples. The method then returns to step 502.

If the monitored temperature ripple does not exceed the ripple limit, the switching frequency of the power module is maintained at the current value, at step 508. The method then returns to step 502. Optionally, a calculation is made using known thermal modelling techniques as to whether the monitored temperature ripple would exceed the ripple limit if the switching frequency of the power module were to be increased. If it would, the current switching frequency is maintained. If the monitored temperature ripple would not exceed the ripple limit at the higher switching frequency, then the switching frequency of the power module may be increased to the higher level to ensure it is at a maximum and to provide optimum performance of the drive 300. In some embodiments, a lower limit may also be specified. This could be a minimum switching frequency, below which the switching frequency should not be reduced, or a minimum p-n junction temperature, Tj, to ensure optimal operation of the power module.

The ripple limit determination of method 400 could be employed at any point in the use of a drive to ensure an up to date ripple limit is being used to control operation of the drive 300. Determination of a ripple limit as discussed above results in a ripple limit that is automatically calculated for its actual application conditions, and that is updated as these conditions change, without requiring user configuration. Online determination of the ripple limit allows the system to adapt to changes in the desired operation of the drive 300. Lifetime is directly controlled by limiting the rate of power module wear to achieve the specified lifetime target in the observed drive conditions. In this way, the ripple limit can be raised as the frequency is lowered (and lowered as the frequency is increased). This has been shown to provide superior performance in elevator applications over a fixed limit.

In any of the above implementations, the drive 300 will always exceed the lifetime specified at step 502 if actual temperature ripples in the drive 300 can be accurately monitored and controlled to the limit described in the reference lifetime characteristic, and the reference lifetime characteristic is correct. This is because the ripple limit is selected to limit the wear rate to an acceptable level under all conditions.

However, during some operating conditions the ripple limit will not be reached and therefore the system is overprotecting the drive. In other words, the constraints imposed may be excessive in some circumstances. To limit the amount of overprotection that is applied, the lifetime protection system can optionally be applied only during times that significant wear is known to occur, for example during acceleration. In acceleration, higher current is required, which results in increased loss in the semiconductor and therefore greater temperature ripple.

Fig. 6 shows a simplified plot of an example operation cycle. The output frequency profile 602 has an acceleration part 604, a steady state part 606 and a deceleration part 608. The acceleration part 604 starts at 0Hz and rises to 40Hz over 5s. The steady state part 606 continues at 40Hz for 16s. The deceleration part 608 ramps down from 40Hz to 0Hz over 5s. The output current profile 610 has an acceleration part 612, a steady state part 614 and a deceleration part 616, which correspond to the acceleration part 604, a steady state part 606 and a deceleration part 608 respectively of the output frequency profile 602. Each of the acceleration part 612, the steady state part 614 and the deceleration part 616 have a constant current value. The acceleration part 612 has a value of 68A, the steady state part 614 has a value of 37A and the deceleration part 616 has a value of 25A. The output current profile 610 in this example also has a step portion 620 at the end of the operation cycle. In elevator applications, in which this example applies, the step portion 620 is for holding the car in position whilst waiting for the mechanical brake to close and remove the load. However, in other applications the step portion 620 may be absent.

An embodiment for selectively applying lifetime protection will now be described. One option for selectively applying lifetime protection is to divide the operating cycle into two sections based on the drive output frequency: (1) transient frequencies that occur during acceleration and deceleration, and (2) a steady state frequency that could occur for longer periods of time. Different ripple limits can then be calculated for the transient parts (the acceleration part 604 and the deceleration part 608) and steady state part 606 of the output frequency profile 602. In this case, the profile duration used in equation 2 is adjusted to the part of the profile for which a limit is being calculated. To calculate the steady state ripple limit, full profile duration is used. To calculate the transient ripple limit, the duration over which the transient frequency is produced is used (i.e., the combined duration of the acceleration part 604 and the deceleration part 608). Alternatively, one limit be calculated for the acceleration part 604 and one for the deceleration part 608. Different frequency values could be used dependent on which limit is being calculated. For example, a threshold value, (e.g. 90% of the steady state travel frequency) or an incremented value (a number of Hz below steady state travel) could be used, or a combination of the two.

Optionally, where the lifetime protection scheme is applied selectively, for example during acceleration only, the lifetime requirement could be scaled so that the ripple limit during these periods is increased to further reduce the level of overprotection. For example, the lifetime requirement could be reduced to cover only the duration of the high wear, acceleration region of the profile. If this approach is applied too liberally (e.g., the ripple limit is exceeded by too much and/or too often), it can result in the lifetime target being missed, however given sufficient knowledge of the application this can be used to achieve the required lifetime target whilst minimising the amount of overprotection and excessive reduction of switching frequency.

As well as the overprotection discussed above, the wear experienced by the drive can also deviate from an expected characteristic. This deviation could be caused by areas of the profile where the ripple limit is not reached, for example due to low load, which would result in additional lifetime compared to the target. Alternatively, deviation could occur where the actual ripples experienced by the product exceed the ripple limit, for example where the minimum switching frequency was reached, which would lead to a reduced lifetime compared to the target. In some applications deviation due to both conditions may be experienced. To remedy this, the lifetime target set at step 402 can be scaled to calculate a temperature ripple limit which compensates for this deviation. A scaling factor can be based on the combination of the factors discussed above that lead to the deviation, and can be updated online to ensure the lifetime target is set to the most relevant value possible.

The theoretical wear at target lifetime is a dimensionless value that, ideally, is 1 which signifies that the lifetime target is reached without overprotection when the drive reaches its target lifetime. If the theoretical wear at target lifetime is less than 1, then too much switching frequency reduction has been applied to date and the drive has been overprotected. If the theoretical wear at target lifetime is greater than 1, then too little switching frequency reduction has been applied and the product will (in theory) fail before the lifetime target has been achieved. The theoretical wear experienced by a drive at its lifetime target can be calculated according to equation 4, below:

$$\textit{Theoretical wear = wear to date x lifetime target/operational time to date} \quad (4)$$

One method of estimating the wear to date is described below. The first step in this estimate is to create a set of set of junction-case temperature ripples experienced by the device. This set can be created in a number of ways.

One method is to regularly record an estimate of the junction-to-case temperature by subtracting estimated junction temperature from measured case temperature. The set can be created from this data-series by using an algorithm such as the rain-flow algorithm. A less computationally expensive, but potentially less accurate approach would be to monitor the junction-to-case temperature by subtracting estimated junction temperature from measured case temperature and adding an element of the corresponding magnitude each time the period of the current ripple rate estimate has elapsed. Optionally the set of junction-case temperatures could be stored as a histogram (i.e. the number of temperature ripples of each magnitude) to reduce the storage space required and to make computations using this data more efficient.

In a second step, the device's lifetime characteristic can be used to determine the wear that each magnitude of temperature ripple would cause. The lifetime characteristic specifies the number of ripples at each magnitude that will result in end of life, and the wear can be calculated as the inverse of this. In a third step, the total wear caused by each temperature ripple can be summed.

Once the theoretical wear has been determined, a scaled lifetime target can be determined by multiplying the lifetime target by the theoretical wear value. The scaled lifetime target can be determined based on equation 5, below:

$$\textit{Scaled lifetime target = lifetime target x theoretical wear} \quad (5)$$

Where the scaled lifetime target is used in place of the original lifetime target in method 400, the resulting ripple limit will be closer to the optimum value (as the wear rate going forward will be increased or decreased to ensure the wear target is reached). This assumes that the value of theoretical wear at target lifetime is accurate. Over the lifetime of the drive, using this modified target should result in the lifetime target being achieved without overprotection. As the theoretical wear is likely to vary significantly during the first hours of operation, it may be necessary to limit its effect. This could be achieved, for example, by setting the theoretical wear value to 1 until a specified operating time had been reached, for example 10 hours.

One advantage of the method 400 is that it can be implemented using relatively few computational resources. In contrast, calculating theoretical wear may be relatively computationally expensive. Fortunately, the theoretical wear value should only change relatively slowly (except during the initial period of operation, as discussed above) and therefore it is not necessary to update this value frequently. This calculation can be performed as a background task in the drive's control software. In this way, the use of a ripple limit provides fast lifetime protection based on the last calculated value of a scaled lifetime target, while this value is updated less frequently to ensure that the lifetime target is achieved without resorting to excessive switch-down.

A temperature control scheme for a power module as discussed above is typically implemented in drive firmware. It is therefore advantageous to have a mechanism for determining a temperature ripple limit as a function of required drive lifetime, operation cycle duration and output frequency limit that can be implemented in drive firmware efficiently. When plotting the temperature ripple limit against output frequency for a fixed lifetime requirement, it is found that curves for different operation cycle durations exhibit a similar trend to one another, with the magnitude of the ripple limit dependent on the operation cycle duration. Therefore, a good approximation of the ripple limit against output frequency can be made by scaling the curve for one operation cycle duration to represent different operation cycle durations.

In this way, the temperature ripple limit values for different operation cycle durations, for example 1s, 4s, 8s, 16s, 20s, 120s, 240s, can be determined and expressed as a percentage of a single ripple limit, for example the 4s characteristic. The average of each of these characteristics was used to produce scaling terms, for example as shown in Table 1. Scaling the 4s characteristic by the terms in Table 1 produces a good approximation of the individually calculated characteristics. This can be implemented in a lookup table to control power module operation.

**Table 1**

| Cycle time (s) | 1 | 4 | 8 | 16 | 20 | 120 | 240 |
|---|---|---|---|---|---|---|---|
| Ripple limit Scaling | 1.20 | 1.00 | 0.91 | 0.83 | 0.80 | 0.63 | 0.57 |

It is found that the average scaling term is inaccurate at output frequencies below 2Hz. Therefore, another method of scaling may be required for this frequency range. As a simplification, ripple variation with frequency is not considered for this range as it is close to a DC condition.

The ripple limit for an output frequency of zero can be determined through a series of simulations, so that the correct amount of switching frequency reduction occurs with the drive's online model. These ripples should not occur more than three times per operation cycle, and so this limit is independent of operation cycle duration.

In some embodiments, the proposed system could form part of a fully automatic switching frequency control scheme with a number of modes of temperature control applied simultaneously. The first mode may be the ripple limit mode described above. In addition, existing junction temperature control schemes could provide further control modes.

For example, a fixed threshold could be applied to the p-n junction temperature $T_j$ to protect against failure from excessive junction temperature. In this case, an upper junction temperature threshold could be implemented to control switch-down of the switching frequency and a lower junction temperature threshold could be implemented to control switch-up of the switching frequency, as is known in the art. Alternatively, different components of the power module could be used to monitor and control temperature, for example a component of the power module having the highest temperature. The upper threshold may be 135°C, and the lower threshold may be 125°C, although it will be appreciated that different values may be used for different drives and applications.

In these embodiments, the switching frequency is reduced if any of the switch-down conditions are reached. The switching frequency is only increased if all of the switch-up conditions are met.

Also disclosed are the following numbered clauses:

1. A method of controlling a switching frequency of a device, the method comprising:

estimating a rate of temperature ripples experienced by the device;
determining the total number of temperature ripples expected over a required lifetime of the device, based on the rate of temperature ripples;
determining and setting a first temperature ripple limit based on the total number of temperature ripples expected over the required lifetime of the device; and
controlling a switching frequency of the device based on the first temperature ripple limit.

2. The method of clause 1, wherein the required lifetime is a number of operation cycles that the device is expected to perform before failure.

3. The method of clause 2, wherein the total number of temperature ripples expected over the required lifetime is further determined based on the number of operation cycles that the device is expected to perform and the duration of a single operation cycle.

4. The method of clause 3, wherein the duration of a single operation cycle is the duration for which the device continuously has a non-zero output current.

5. The method of clause 3 or 4, wherein the duration of an operation cycle is an average duration determined based on a duration of at least one previous operation cycle.

6. The method of clause 5, wherein the at least one previous operation cycle is the preceding operation cycle.

7. The method of clause 1, wherein the required lifetime is a period for which the device is expected to operate before failure.

8. The method of clause 7, wherein the total number of temperature ripples expected over the required lifetime is further determined based on the period for which the device should operate.

9. The method of any preceding clause, wherein determining the rate of temperature ripples comprises determining the instantaneous rate of temperature ripples experienced by the device.

10. The method of clause 9, wherein determining the instantaneous rate of temperature ripples further comprises determining the instantaneous output frequency of the device.

11. The method of clause 10, wherein the instantaneous rate of temperature ripples is estimated based on the instantaneous output frequency of the device.

12. The method of clause 11, wherein the instantaneous rate of temperature ripples is considered equal to the instantaneous output frequency of the device.

13. The method of clause 11, wherein the instantaneous rate of temperature ripples is considered equal to the sum of the instantaneous output frequency of the device and the frequency of operation cycles of the device.

14. The method of any preceding clause, wherein determining the first temperature ripple limit comprises matching the total number of temperature ripples to a magnitude of temperature ripples based on a characteristic of the device, the characteristic defining the total number of temperature ripples of a given magnitude that the device can withstand before failure.

15. The method of clause 14 wherein the characteristic is determined by at least one of experimental results, computer simulation and data supplied by the device manufacturer.

16. The method of clause 14 or 15, wherein the characteristic is at least one of a graphical curve, a lookup table and a set of polynomial coefficients.

17. The method of any preceding clause, further comprising determining a second temperature ripple limit.

18. The method of clause 17, wherein the second temperature ripple limit is determined in substantially the same manner as determining the first temperature ripple limit.

19. The method of clause 17 or 18, wherein the first temperature ripple limit is used with a first portion of an operation cycle of the device and the second temperature ripple limit is used with a second portion of the operation cycle of the device.

20. The method of clause 19, wherein the first portion of the operation cycle is a portion having a steady state frequency output and the second portion of the operation cycle is a portion having a transient frequency output.

21. The method of any preceding clause, wherein the device is a variable speed drive.

22. The method of clause 21, wherein the variable speed drive is an elevator drive.

23. The method of any preceding clause, wherein the step of controlling the switching frequency comprises:

monitoring a temperature ripple experience by the device at a first switching frequency;
determining if the monitored temperature ripple is above the first temperature ripple limit; and
if the monitored temperature ripple is above the first temperature ripple limit, setting the switching frequency of the device to a second switching frequency lower than the first switching frequency.

24. The method of any preceding clause, wherein the temperature ripple is a temperature ripple experienced by a component of the device.

25. The method of clause 24, wherein the component of the device is the component of the device with the highest absolute temperature in operation.

26. The method of clause 24, wherein the component of the device is a p-n junction of an inverter of the device.

27. The method of any of clauses 23 to 26, wherein the second switching frequency is higher than a predetermined minimum switching frequency.

28. The method of any preceding clause, further comprising:

determining a modified lifetime for the device based on the required lifetime and a theoretical wear that the device will experience at its target lifetime; and
determining the total number of temperature ripples expected over the modified lifetime of the device.

29. The method of clause 28, wherein the theoretical wear is determined based on the wear currently experienced by the device and a proportion of the required lifetime that has elapsed.

30. The method of clause 29, wherein the wear currently experienced by the device is determined based on the amount of wear that the device has experience over each temperature ripple.

**Claims**

1. A method of controlling a switching frequency of a device, the method comprising:

   estimating a rate of temperature ripples experienced by the device;
   determining the total number of temperature ripples expected over a required lifetime of the device, based on the rate of temperature ripples;
   determining and setting a first temperature ripple limit based on the total number of temperature ripples expected over the required lifetime of the device; and
   controlling a switching frequency of the device based on the first temperature ripple limit.

2. The method of claim 1, wherein the required lifetime is a number of operation cycles that the device is expected to perform before failure.

3. The method of claim 2, wherein the total number of temperature ripples expected over the required lifetime is further determined based on the number of operation cycles that the device is expected to perform and the duration of a single operation cycle.

4. The method of claim 3, wherein the duration of a single operation cycle is the duration for which the device continuously has a non-zero output current.

5. The method of claim 3 or 4, wherein the duration of an operation cycle is an average duration determined based on a duration of at least one previous operation cycle.

6. The method of any preceding claim, wherein determining the rate of temperature ripples comprises determining the instantaneous rate of temperature ripples experienced by the device.

7. The method of claim 6, wherein determining the instantaneous rate of temperature ripples further comprises determining the instantaneous output frequency of the device.

8. The method of any preceding claim, wherein determining the first temperature ripple limit comprises matching the total number of temperature ripples to a magnitude of temperature ripples based on a characteristic of the device, the characteristic defining the total number of temperature ripples of a given magnitude that the device can withstand before failure.

9. The method of any preceding claim, further comprising determining a second temperature ripple limit.

10. The method of claim 9, wherein the first temperature ripple limit is used with a first portion of an operation cycle of the device and the second temperature ripple limit is used with a second portion of the operation cycle of the device.

11. The method of claim 10, wherein the first portion of the operation cycle is a portion having a steady state frequency output and the second portion of the operation cycle is a portion having a transient frequency output.

12. The method of any preceding claim, wherein the device is a variable speed drive.

13. The method of any preceding claim, wherein the step of controlling the switching frequency comprises:

    monitoring a temperature ripple experience by the device at a first switching frequency;
    determining if the monitored temperature ripple is above the first temperature ripple limit; and
    if the monitored temperature ripple is above the first temperature ripple limit, setting the switching frequency of the device to a second switching frequency lower than the first switching frequency.

14. The method of claim 13, wherein the second switching frequency is higher than a predetermined minimum switching frequency.

15. The method of any preceding claim, further comprising:

    determining a modified lifetime for the device based on the required lifetime and a theoretical wear that the device will experience at its target lifetime; and
determining the total number of temperature ripples expected over the modified lifetime of the device.

**Fig.1**

**Fig.2**

Fig.3

## 400

```
        ┌─────────────────────────┐
        │  Specify a target lifetime │
402 ────│                         │
        └─────────────────────────┘
                     │
                     ▼
        ┌─────────────────────────┐
        │    Determine current     │
404 ────│  temperature ripple rate │
        └─────────────────────────┘
                     │
                     ▼
        ┌─────────────────────────┐
        │  Estimate total number of │
406 ────│   temperature ripples    │
        └─────────────────────────┘
                     │
                     ▼
        ┌─────────────────────────┐
        │  Determine temperature   │
408 ────│     ripple limit         │
        └─────────────────────────┘
```

**Fig.4**

## 500

```
              ┌─────────────────────────┐
              │   Monitor temperature    │
        502 ──│                         │
              └─────────────────────────┘
                           │
                           ▼
                   ◇ Determine if  ◇
                   ◇ magnitude of  ◇
                   ◇  monitored    ◇───── NO ──┐
                   ◇ temperature   ◇           │
                   ◇   ripples     ◇           │
                   ◇ exceeds ripple◇           │
                   ◇    limit    504◇          │
                           │                   │
                          YES                  │
                           ▼                   │
              ┌─────────────────────────┐      │
              │    Reduce switching      │      │
        506 ──│   frequency of drive     │      │
              └─────────────────────────┘      │
                           │                   │
                           ▼                   │
              ┌─────────────────────────┐      │
              │ Maintain current switching│◄────┘
        508 ──│   frequency of drive     │
              └─────────────────────────┘
```

**Fig.5**

**Fig.6**

Europäisches
Patentamt

European
Patent Office

Office européen
des brevets

# EUROPEAN SEARCH REPORT

Application Number

EP 18 21 5578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/080024 A1 (WEI LIXIANG [US] ET AL) 1 April 2010 (2010-04-01) | 1-14 | INV. H03K17/693 |
| Y | * figures 6, 7 * | 15 | |
| Y | US 2005/071090 A1 (KATOU MASANORI [JP]) 31 March 2005 (2005-03-31) * abstract * | 15 | |
| A | GB 2 503 779 A (CONTROL TECH LTD [GB]) 8 January 2014 (2014-01-08) * the whole document * | 9-11 | |

TECHNICAL FIELDS
SEARCHED (IPC)

H03K
H02M

The present search report has been drawn up for all claims

| Place of search | Date of completion of the search | Examiner |
|---|---|---|
| The Hague | 18 April 2019 | Loiseau, Ludovic |

EPO FORM 1503 03.82 (P04C01)

## ANNEX TO THE EUROPEAN SEARCH REPORT
## ON EUROPEAN PATENT APPLICATION NO.

EP 18 21 5578

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2019

| Patent document cited in search report | | Publication date | Patent family member(s) | | Publication date |
|---|---|---|---|---|---|
| US 2010080024 | A1 | 01-04-2010 | CN | 101714824 A | 26-05-2010 |
| | | | CN | 105846757 A | 10-08-2016 |
| | | | US | 2010080024 A1 | 01-04-2010 |
| US 2005071090 | A1 | 31-03-2005 | CN | 1618164 A | 18-05-2005 |
| | | | DE | 10392498 T5 | 09-02-2006 |
| | | | GB | 2405538 A | 02-03-2005 |
| | | | JP | 4367339 B2 | 18-11-2009 |
| | | | JP | WO2004082114 A1 | 15-06-2006 |
| | | | KR | 20040111600 A | 31-12-2004 |
| | | | TW | 591879 B | 11-06-2004 |
| | | | US | 2005071090 A1 | 31-03-2005 |
| | | | WO | 2004082114 A1 | 23-09-2004 |
| GB 2503779 | A | 08-01-2014 | CN | 103384123 A | 06-11-2013 |
| | | | GB | 2503779 A | 08-01-2014 |

EPO FORM P0459

For more details about this annex : see Official Journal of the European Patent Office, No. 12/82

**EP 3 503 400 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140346989 A1